(19) Europäisches Patentamt
European Patent Office
Office européen des brevets

(11) **EP 2 713 137 B1**

(12) **EUROPEAN PATENT SPECIFICATION**

(45) Date of publication and mention
of the grant of the patent:
**01.11.2017  Bulletin 2017/44**

(51) Int Cl.:
***G01B 7/14*** *(2006.01)*

(21) Application number: **13186769.9**

(22) Date of filing: **30.09.2013**

(54) **Target clearance measurement device**

Zielabstandsmessvorrichtung

Dispositif de mesure d'un dégagement de cible

(84) Designated Contracting States:
**AL AT BE BG CH CY CZ DE DK EE ES FI FR GR HR HU IE IS IT LI LT LU LV MC MK MT NL NO PL PT RO RS SE SI SK SM TR**

(30) Priority: **28.09.2012  GB 201217434**

(43) Date of publication of application:
**02.04.2014  Bulletin 2014/14**

(73) Proprietor: **Salunda Limited
Howes Lane
Bicester
Oxfordshire OX26 2UA (GB)**

(72) Inventors:
• **Wherritt, Peter**
  **Abingdon, Oxfordshire OX13 5BE (GB)**
• **Harrison, Martin Roy**
  **Brackley, Northamptonshire NN13 5SF (GB)**
• **Karenowska, Alexy Davison**
  **Oxford, Oxfordshire OX1 4AU (GB)**
• **Gregg, John Francis**
  **Oxford, Oxfordshire OX1 4AU (GB)**
• **Pickles, Philip**
  **Oxford, Oxfordshire OX2 9HA (GB)**

(74) Representative: **J A Kemp
14 South Square
Gray's Inn
London WC1R 5JJ (GB)**

(56) References cited:
**WO-A1-01/92817        DE-A1- 3 305 546
JP-A- H10 281 806     US-A- 3 780 859
US-A- 5 519 317         US-A1- 2004 155 666
US-B1- 6 239 593**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

## Description

The present invention relates to a target clearance measurement device and in particular an aero engine turbine rotor blade clearance measurement device.

Under normal operating conditions, the radial and axial position(s) of the blade(s) of an aero engine jet turbine vary over a range of up to several millimetres relative to their position when the engine is cold and unloaded. So as to optimize the efficiency of an engine it is desirable to measure and control the speed and position of the turbine blades relative to the engine casing. One means to implement such a measurement system is to install a device in the engine casing capable of a) detecting the presence/proximity of the blade tips and/or measuring the distance between the casing and the blades ("the blade clearance" b) measuring the blade pass rate, from which the rotational speed of the turbine may be inferred.

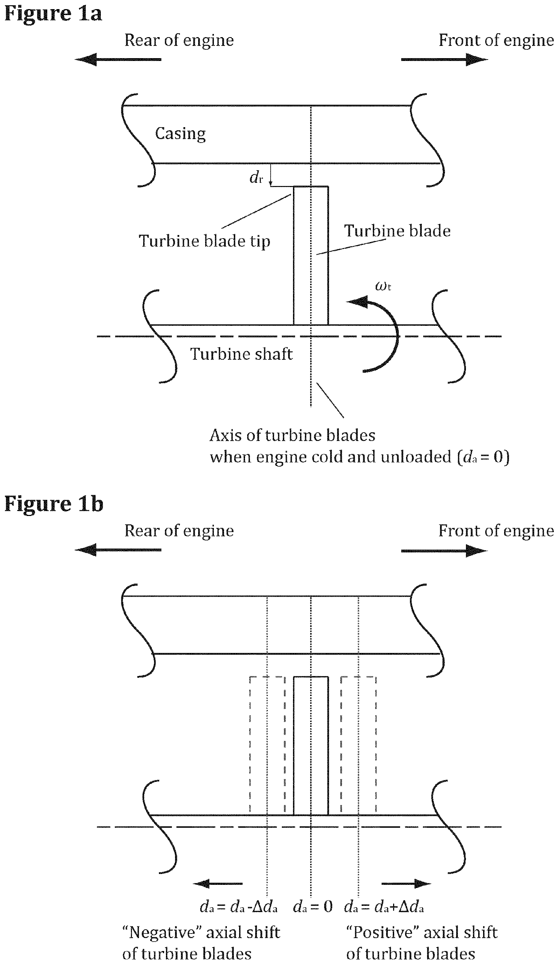

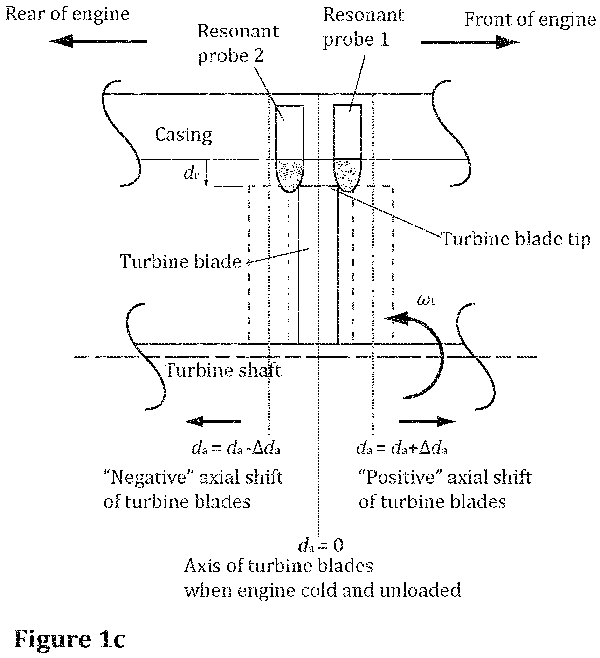

In the context of such a measurement, two quantities are important: the radial distance between the blade tips and the turbine casing, and the axial position of the turbine blades relative to a fixed point on the casing. The latter may be quantified in terms of an axial offset $d_a$ between the turbine blades and a fixed point on the turbine casing defined such that when the engine is cold and unloaded $d_a = 0$ (see Fig. 1a).

The radial blade tip to casing distance $d_r$ takes a maximum value when the engine is cold and unloaded and reduces under load as a result of the combined effects of heating and centripetal acceleration of the blades. Axial shift of the blades is due to the displacement of the turbine under load. Relative to its position in the cold, static engine, the majority of the axial shift of the turbine is toward the rear of the casing (negative shift), but a small displacement toward the front of the engine (positive shift) is also possible (see Fig. 1b).

A first technology (US2010213929, WO2010082035 and associated applications) has been developed and optimized for accurate quantitative measurements of the blade-tip clearance $d_r$. However, this approach only delivers good results over a relatively restricted range of axial offset values $d_a$.

Therefore, there is required a system and method which combines the advantages of long-range functionality and high-accuracy clearance measurement capability.

DE-A-3,305,546, on which the two part form of claim 1 is based, discloses a target measurement device comprising:

    a measurement probe containing a coil and having some inductance and some capacitance and an admittance and a resonance frequency that change as the separation of the measurement probe and a target changes; and
    a frequency source arranged to apply at an amplitude, an input alternating signal to the measurement probe;
    a frequency regulator arranged to regulate the input alternating signal at a frequency below the resonance frequency of the measurement probe; and
    a detector arranged to detect an output signal from the measurement probe at the frequency of the frequency source that varies in amplitude with the admittance and resonance frequency of the measurement probe indicating an interaction of the measurement probe with the target.

## Summary of the Invention

Against this background and in accordance with a first aspect there is provided a target measurement device comprising: a measurement probe containing a coil and having some inductance and some capacitance and an admittance and resonance frequency that change as the separation of the measurement probe and a target or rotor blade changes; a frequency source arranged to apply at an amplitude, an input alternating signal to the measurement probe; a frequency regulator arranged to regulate the input alternating signal at a frequency below the resonance frequency of the measurement probe; a detector arranged to detect an output signal from the measurement probe at the frequency of the frequency source that varies in amplitude with the admittance and resonance frequency of the measurement probe indicating an interaction of the measurement probe with the target; and a circuit arranged to scale the amplitude of the output signal detected by the detector according to the amplitude of the input signal provided by the frequency source, wherein the frequency source is regulated to a frequency which is, both in the presence and absence of interaction between the measurement probe and a target, simultaneously: (a) not less than $\omega_0/Q$ below the resonance frequency $\omega_0$ of the measurement probe, $Q$ being the quality factor of the measurement probe, and (b) not below the frequency $\omega_L = R^*/L$ where $R^*$ is the sum of a source impedance from which the measurement probe is driven and its resistance, and $L$ is its inductance.

The frequency source, frequency regulator, detector and scaling circuit form part of measurement circuitry.

The system described above affords both (1) high sensitivity and thus long measurement range (achieved by means of the particular configuration of the frequency source, frequency regulator, and detector described), and (2) the ability to make highly accurate measurements of the absolute blade clearance (achieved by means of the amplitude scaling circuitry).

Optionally, the target measurement device further comprises a feature or features to enable the real-time monitoring of the integrity of the measurement probe. Such feature(s) facilitate the identification of measurement probe failure which is advantageous from the point of view of safeguarding the integrity and proper functioning of the engine in which the device is installed. One such optional feature is a circuit which passes a small DC current through the measurement probe. In one preferred implementation of such a circuit, this current is arranged to flow by connecting the probe between two non-equal voltages $V_A$ and $V_B$ ($V_A > V_B$) via two resistors: one from $V_A$ to one end of the probe (*a*) the other from $V_B$ to the other end of the probe (*b*). If the probe is intact, the voltages at a and b are respectively, slightly below $V_A$, and slightly above $V_B$. If the probe fails in an open-circuit fashion, the voltage at a is equal to $V_A$, and the voltage at *b* is equal to $V_B$. If the probe fails by shorting to ground, either one or both of the voltages at a or *b* is ground. By measuring the voltage difference across the probe, its resistance can be calculated. This resistance is, in turn, a measure of the temperature of the coil inside the probe. Knowledge of this temperature can be used to improve the accuracy of the blade clearance measurement. In such an implementation of a real-time monitoring feature, it is necessary to ensure that the current path through the probe and the resistors does not load the AC circuitry associated with the frequency source and detector. For this purpose, a filter is preferably employed.

Optionally, the target measurement device further comprises a feature or features for verifying that the measurement circuitry is fully functional. In one preferred implementation of such a validation feature a switchable electrical impedance is placed across the connections from the measurement circuitry to the probe. In normal operation this impedance is switched out of circuit. However, when verification of the proper functioning of the measurement circuitry is required, the impedance is switched alternately in and out of the circuit (at a frequency, for example, of 1 kHz, though a wide range of other frequencies may be used). Viewed from the measurement circuitry, the effect of this switching is equivalent to that produced by interaction between the measurement probe and passing targets or rotor blades. Hence, the switched impedance creates a "simulated" blade-pass signal. Analyzing the response of the measurement circuitry to this simulated blade-pass signal allows the integrity both of the measurement circuitry, and of the measurement probe to be verified.

Preferably, $Q$ may be between 2 and 20. Other values of $Q$ may be used such as below 50 and between 10 and 20, for example and the $Q$ may vary depending on the operating conditions of the measurement device.

Preferably, the frequency source may be regulated to between 100 KHz and 400 MHz but other radio- or microwave-frequencies may be used.

Optionally, the measurement circuitry may be further arranged to indicate that the target or rotor blade clearance is within a range of clearances.

Optionally, the target comprises rotor blades and the target measurement device is further configured to provide an indication of a speed or speed of rotation of the rotor blades by detecting the rate at which the rotor blades pass in front of the measurement probe.

Optionally, the detector of the target measurement device further comprises a fast analogue to digital converter gate array based signal processing circuit used to measure or monitor the profiles of the passing blades.

Optionally, the measurement circuitry may be further configured to determine at intervals the resonance frequency of the measurement probe. This may improve clearance measurement accuracy by calibrating the device at intervals or when the rotor blades are stationary.

According to a second aspect there is provided a system comprising: a plurality of the target clearance measurement devices according to the foregoing description; a single transmission line configured to provide an electrical connection between each measurement probe and its corresponding measurement circuitry, wherein each measurement circuitry is configured to operate its corresponding probe at a different frequency. Therefore, an array or arrangement of measurement devices may be used with reduced cabling.

According to a third aspect there is provided a method of measuring target comprising the steps of: providing a measurement probe containing a coil having some inductance and some capacitance and an admittance and resonance frequency that change as the separation of the measurement probe and a target or rotor blade changes; driving the measurement probe with an input alternating signal regulated to a frequency below the resonance frequency of the measurement probe; detecting an output signal from the measurement probe at the frequency of the input alternating signal that varies in amplitude with the admittance and resonance frequency of the measurement probe indicating an interaction of the measurement probe with a target or rotor blade; and scaling the amplitude of the output signal detected according to the amplitude of the input signal provided by the frequency source, wherein the frequency source is regulated, both in the presence and absence of interaction between the measurement probe and the target, to a frequency which is, simultaneously: (a) not less than $\omega_0/Q$ below the resonance frequency $\omega_0$ of the measurement probe ($Q$ being the quality factor of the measurement probe), and (b) not below the frequency $\omega_L = R^*/L$ where $R^*$ is the sum of a source impedance from which the measurement probe is driven and its resistance, and $L$ is its inductance.

Optionally, the method may further comprise the step of determining the resonance frequency of the measurement probe and regulating the frequency source through the use of the frequency regulator to operate at a frequency below this determined resonance frequency.

Optionally, the method may further comprise the step of monitoring the integrity of the measurement probe in real time by means of passing a small current through the measurement probe which is arranged to flow by connecting the probe between two non-equal voltages $V_A$ and $V_B$ via two resistors: one from $V_A$ to one end of the probe, the other from $V_B$ to the other end of the probe, measuring the voltage difference across the probe, and using a filter to prevent the current path through the resistors and the probe from loading the AC circuitry associated with the frequency source and detector.

Optionally, the method may further comprise the step of verifying that the measurement circuitry is fully functional by switching an electrical impedance across the connections from the measurement circuitry to the probe in a controlled manner.

Preferably, $Q$ may be between 2 and 20. Other values of $Q$ may be used such as below 50 and between 10 and 20, for example and the $Q$ may vary depending on the operating conditions of the measurement device.

Preferably, the frequency source is regulated to between 100 KHz and 400 MHz but other radio- or microwave-frequencies may be used.

The methods described above may be implemented as a computer program comprising program instructions to operate a computer, processor or integrated circuit. The computer program may be stored on a computer-readable medium or stored as firmware.

It should be noted that any feature described above may be used with any particular aspect or embodiment of the invention.

The present invention may be put into practice in a number of ways and embodiments will now be described by way of example only and with reference to the accompanying drawings, in which:

FIG. 1a shows a schematic diagram in cross section of a part of a turbine engine;
FIG. 1b shows a further schematic diagram in cross section of a part of a turbine engine illustrating a shift in rotor blade position;
FIG. 1c shows a further schematic diagram in cross section of a part of a turbine engine including two measurement probes mounted in axially offset positions;
FIG. 2a shows a schematic diagram of a resonant measurement probe and measurement circuitry;
FIG. 2b shows a schematic diagram of the measurement probe of FIG. 2a in greater detail interacting with a tip of a rotor blade;
FIG. 3 shows a more detailed schematic diagram of the measurement circuitry shown in FIG. 2a;
FIG. 4a shows a schematic diagram of an equivalent circuit of the probe of FIG. 2a;
FIG. 4b shows a second schematic diagram of an equivalent circuit of the probe of FIG. 2a;
FIG. 5 shows a graph of admittance (y-axis) of the probe of

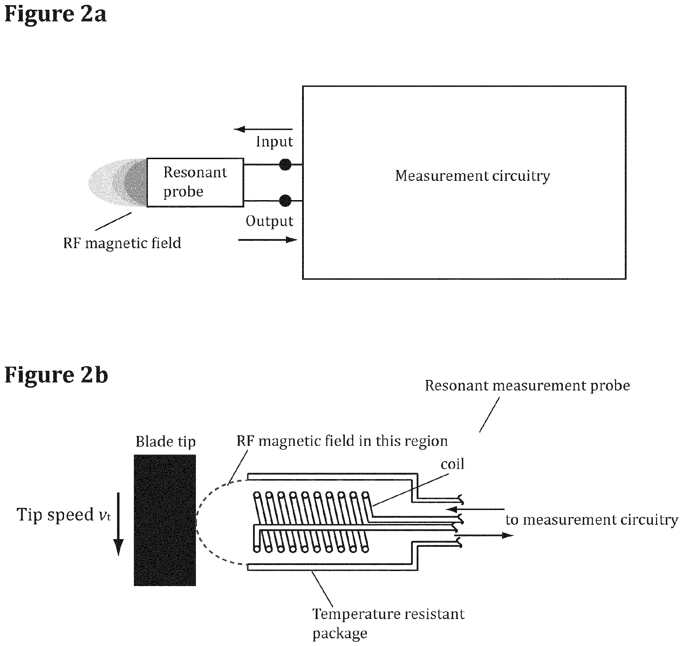

FIG. 2a against frequency (x-axis) with and without a target or rotor blade in proximity;

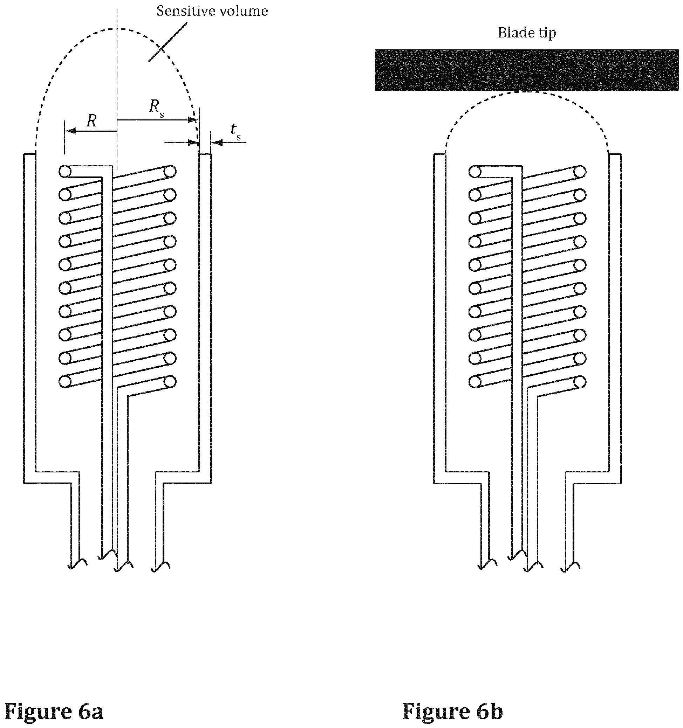

FIG. 6a shows a schematic diagram of the probe of FIG. 2a in cross section including a metallic screen indicating a sensitive volume of space;
FIG. 6b shows a schematic diagram of the probe of FIG. 2a in cross section indicating a sensitive volume of space changing shape when in proximity to the target or rotor blade;

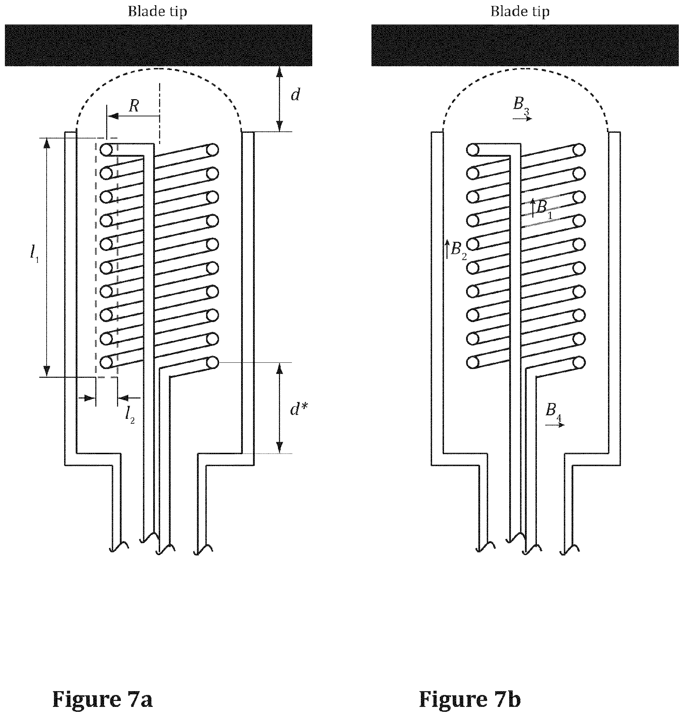

FIG. 7a shows a schematic diagram of the probe of FIG. 2a in cross section indicating the interaction with the target or rotor blade; and
FIG. 7b shows a further schematic diagram of the probe of
FIG. 2a in cross section indicating the interaction with the rotor blade.

It should be noted that the figures are illustrated for simplicity and are not necessarily drawn to scale.

The measurement device has two components: a resonant measurement probe containing a coil having some inductance and some capacitance, and a set of measurement circuitry ("the measurement circuitry") (Fig. 2a), connected via electrical interconnects (e.g. coaxial transmission line(s)) of arbitrary length.

**The measurement probe**

The measurement probe includes a coil wound from one or more isolated layers of conducting wire (which might for example be copper or platinum wire) encapsulated in a temperature-resistant package. The coil may be wound on a mandrel. In operation, a radio-frequency (RF) alternating current flows through the coil, giving rise to an RF magnetic field in its vicinity. The package may be designed to partially screen the coil in such a way that when the probe is installed in the engine, its RF magnetic field extends into and only into the region through which the blades pass. One such possible configuration is illustrated in Fig. 2b but as will be appreciated by the reader, many others are possible. Further, the dimensions and geometry of the coil and package may be generally chosen such that the cross-sectional area of the RF magnetic field is, at its largest, smaller or significantly smaller than the tip area of an individual blade so that at any instant in time the maximum number of individual blade tips in the region of the RF magnetic field is either one or two: the former condition corresponding to case that the blade to blade gap is large in comparison with the characteristic dimension of the RF field, the latter to the case that it is small.

The measurement probe is engineered to have a particular resonant response having at least one (but possibly more than one) resonance frequency. In one preferred implementation, this resonant response is wholly or substantially defined by the combination of the self-inductance and inter-winding and layer capacitances of the coil. In another, it may be partly defined by other electrical components or elements (for example lumped capacitors) connected to the coil.

In operation, the measurement probe is excited at a frequency which lies below its resonance frequency if it has just one such frequency or a *particular one* of its resonance frequencies (generally, but not necessarily the lowest) if it has multiple such frequencies. From henceforth, when we refer to "the resonance frequency" of the measurement probe, this should be understood to mean "the resonance frequency or the particular resonance frequency" of the measurement probe.

### The measurement circuitry

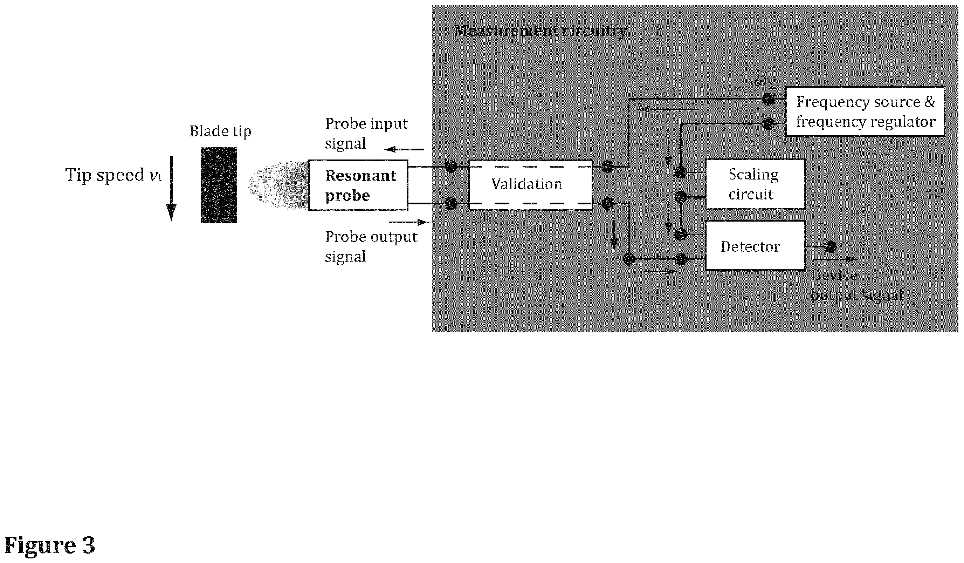

The measurement circuitry, illustrated schematically in Fig. 3, may be subdivided into four parts:

    1. A frequency source and frequency regulator (or regulated frequency source).
    2. A detector.
    3. A scaling circuit.
    4. A validation section.

### The frequency source and frequency regulator

The role of the frequency source and frequency regulator (or regulated frequency source) is to supply the measurement probe with an input alternating drive signal, having a regulated frequency generally in the radio-frequency (RF) range. In one preferred implementation of the measurement device, the output of the frequency source is regulated to a single fixed frequency $\omega_1$ and frequency regulation is provided by, for example, a crystal. In another, the frequency of the frequency source may be varied in response to changes in the operating conditions of the measurement device using, for example, frequency regulation based on a variable frequency oscillator operating in conjunction with a subsidiary control loop. In such a case, the variable frequency oscillator may either have a continuously variable operating frequency, or may be such that it can be operated at a plurality of fixed frequencies. The input alternating drive signal will have an amplitude.

The frequency source may be arranged to operate either continuously or in a pulsed or switched mode. If it is operated in a pulsed mode, the duty cycle of the pulses may be fixed or variable.

A particular feature of the measurement device is that the frequency of the frequency source is always (i.e. under all conditions of operation or use) regulated to *below* the resonance frequency of the measurement probe.

Particularly, the frequency source is regulated to a frequency which is, for all operating conditions and both in the presence and absence of interaction between the measurement probe and a rotor blade, simultaneously: (a) not less than $\omega_0/Q$ below the resonance frequency $\omega_0$ of the measurement probe ($Q$ being the quality factor of the measurement probe), and (b) not below the frequency $\omega_L = R^*/L$ where $R^*$ is the sum of the source impedance from which the measurement probe is driven and its resistance, and $L$ is its inductance.

$Q$ may be between or substantially between 10 and 20, for example. The probe may be configured to have other values of $Q$ and the $Q$ may change depending on the operating conditions of the measurement device.

### The detector

The role of the detector is to receive an output signal from the measurement probe at the frequency of the frequency source and to derive from this a measurement signal indicative of the blade clearance, the frequency of blade-pass events, and, in some implementations, the spatial profiles of the blades. A blade-pass event may be defined as a passing of a single blade tip within range of the measurement probe. The occurrence of such an event is signalled by an amplitude modulation of the probe output signal at the frequency of the frequency source. The closer the blade to the measurement probe, the larger this amplitude modulation.

The detector may include a demodulator for demodulating the probe output signal. As will be appreciated by the skilled reader, a wide range of demodulator designs are possible. These include, for example, a diode based envelope detector or coherent detectors (such as might, for example, operate via a multiplication of an amplitude regulated derivative of the output signal from the frequency source with the probe output signal).

Optionally, real-time or post processing of the detected output from the measurement probe (using either analogue or digital electronics, or a combination of these) may be incorporated. For example, and particularly, the detector may include a fast analogue to digital converter gate array based signal processing circuit used to measure or monitor the profiles of the passing blades.

**The scaling circuit**

The function of the scaling circuit is to provide the means for the amplitude of the probe output signal detected at the detector to be scaled according to that of the probe input signal (which may vary due to various factors, including the operating conditions of the measurement device), thus enabling more consistent and more accurate absolute blade clearance measurements to be made.

**The validation section**

The role of the validation section is to provide the means to verify that the measurement device (both the measurement probe and the measurement circuitry) is operating normally. In one preferred embodiment of such a validation section, a system for real-time monitoring of the integrity of the probe is incorporated in the form of a circuit which passes a small current through the measurement probe. In one preferred implementation of such a circuit, this current is arranged to flow by connecting the probe between two non-equal voltages $V_A$ and $V_B$ ($V_A > V_B$) via two resistors: one from $V_A$ to one end of the probe *(a)* the other from $V_B$ to the other end of the probe *(b)*. If the probe is intact, the voltages at a and b are respectively, slightly below $V_A$, and slightly above $V_B$. If the probe has failed in an open-circuit fashion, the voltage at a is equal to $V_A$, and the voltage at $b$ is equal to $V_B$. If the probe has failed by shorting to ground, either one or both of the voltages at a or b is ground. By measuring the voltage difference across the probe, the resistance of the probe can be calculated. This resistance is, in turn, a measure of the temperature of the coil inside the probe. Knowledge of this temperature can be used to improve the accuracy of the blade clearance measurement. In such an implementation of a real-time monitoring feature, it is necessary to ensure that the current path through the probe and the resistors does not load the AC circuitry associated with the frequency source and detector. For this purpose, a filter is preferably employed.

In another preferred embodiment of such a validation section, a circuit is incorporated which has the function of switching an electrical impedance across the connections from the measurement circuitry to the probe in a controllable fashion. In normal operation this impedance is switched out of circuit but, by switching it alternately in and out of the circuit, (at a frequency, for example, of 1 kHz, though a wide range of other frequencies may be used) it can be used when required to verify the proper functioning of the measurement device.

**Operational features of the measurement device**

**Overview of operational features of the measurement device**

The operation of the measurement device is as follows: The frequency source included in the measurement circuitry excites the measurement probe with an input alternating (generally radio-frequency, RF) signal at a fixed frequency $\omega_1$ regulated to below its resonance frequency $\omega_0$ under all operating conditions of the measurement device. In operation, the resonance frequency of the measurement probe may be subject to alteration through two mechanisms:

1. Interaction with a blade or blade(s) (which increases its frequency).
2. Environmental factors, notably temperature (which may increase or decrease its frequency).

Therefore, and particularly, the detuning of the frequency source relative to the resonance frequency of the measurement probe is chosen to be sufficiently large that the maximum possible downward shift through mechanism (2) cannot cause it to reduce to zero.

Interaction between the RF magnetic field from the measurement probe and the target or rotor blade(s) has two effects: Firstly, as alluded to above, it causes the resonance frequency of the probe to increase. Secondly, it increases the loss in the measurement probe (that is, it reduces its quality or *Q*-factor). *Both* of these effects lead to an increase in the admittance of the measurement probe at the frequency $\omega_1$ of the frequency source and therefore to an increase in the probe output signal associated with a given amplitude of probe input signal.

**General operational strengths of the measurement device**

1. The measurement device achieves advantageous sensitivity and therefore range by virtue of the fact that by operating at a *fixed* or constant frequency *below* the resonance frequency of the measurement probe, *two* effects; (*i*) the modification of the resonance frequency of the measurement probe, and (*ii*) the modification of the *Q* of the probe, contribute to a blade clearance measurement signal which is an amplitude modulation at the source frequency.

2. The measurement device is capable of making highly accurate measurements of absolute blade clearance. This is made possible by the inclusion of the scaling circuit in the measurement circuitry. The scaling circuit is arranged to provide for the detected amplitude of the probe output signal to be scaled according to the amplitude of the probe input signal from the frequency source, thus compensating for changes which might occur in normal operation and would otherwise lead to error.

3. The described measurement device shows excellent immunity to changes in the conductivity of the rotor blades (and is also suitable for use in conjunction with rotor blades or other targets having a wide range of conductivities).

4. The measurement circuitry lends itself to modular design and construction.

5. The measurement device features excellent robustness to changes or adjustments to the lengths of the cables connecting the probe to the measurement circuitry. It is thus suitable for use on production engines as a Line Replaceable Unit (LRU). Either measurement probe or measurement circuitry manufactured to appropriate tolerances may be exchanged reducing the need for calibration or other adjustment.

6. The incorporation of the validation features described in the preceding text allows the operational integrity of the measurement probe and measurement circuitry to be monitored in real time.

7. The possibility of incorporating real-time or post processing of the output from the measurement device allows detailed information about blade profiles to be derived.

**Operating principles of the measurement device**

**Equivalent circuit model of the resonant measurement probe assembly**

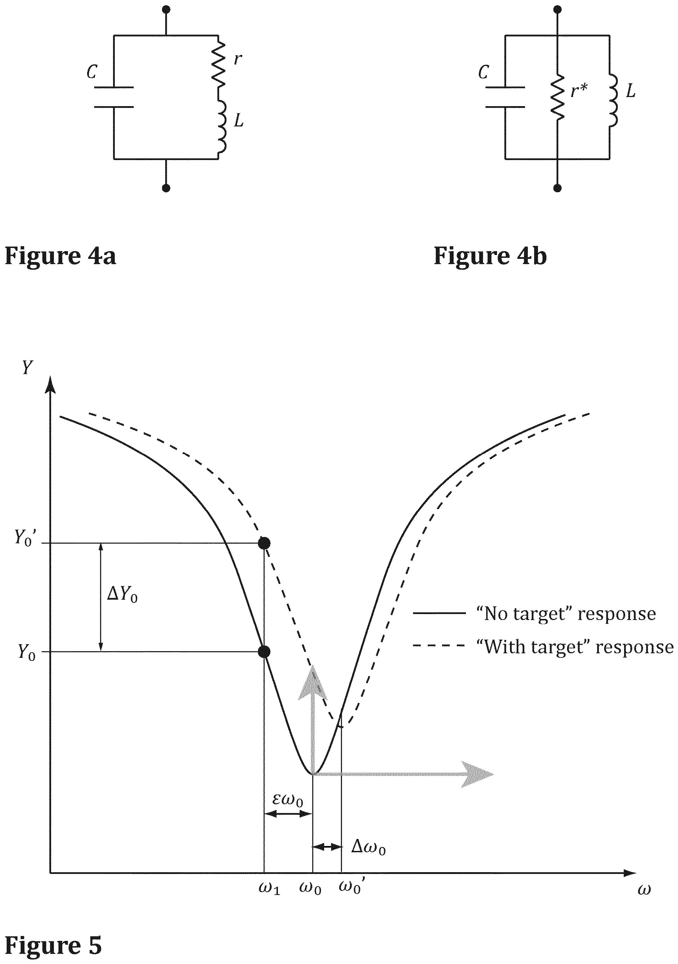

The electrical characteristics of the measurement probe may be analyzed with reference to an equivalent circuit of the form shown in Fig. 4a. The circuit has three components; an inductance $L$ connected in series with a resistance $r$ in shunt with a capacitance $C$. $L$ represents the effective inductance of the measurement probe coil, $r$ its loss equivalent resistance. $C$ is the effective capacitance of the probe (originating from the parasitic capacitance of the coil inside it and any external capacitance). The admittance $Y$ of the circuit at frequency $\omega$ is given, for $\omega L \gg r$, by

$$Y = \frac{1 - \omega^2 LC + \mathrm{j}\omega Cr}{r + \mathrm{j}\omega L} \tag{1}$$

Equation 1 may be rewritten

$$Y = \frac{1}{r^*} + \frac{1}{\mathrm{j}\omega L} + \mathrm{j}\omega C \tag{2a}$$

where we define a (purely real) "transformed resistance"

$$r^* = \frac{\omega^2 L^2}{r} \tag{2b}$$

By inspection of Eqns. 2, the equivalent circuit of Fig. 4a may be redrawn in the form shown in Fig. 4b: three components, admittances $1/r^*$, $1/\mathrm{j}\omega L$ and $\mathrm{j}\omega C$ connected in shunt.

The resonance frequency $\omega_0$ of the measurement probe is the frequency at which the admittance $Y$ is a minimum:

$$\omega_0 = \frac{1}{\sqrt{LC}} \qquad (3)$$

**Electrical characteristics of the measurement probe assembly**

The influence of interaction between the measurement probe and a target may be modelled as interaction dependent changes $\Delta L$ and $\Delta r^*$ in the effective inductance and transformed resistance of the equivalent circuit of Fig. 4b.

Benefits of the system include that the interaction between the measurement probe and the rotor blade (i.e. target) results in either or both of:

    1. A progressive *decrease* in the effective inductance $L$ with increasing interaction with the target.
    2. A progressive *decrease* in the transformed resistance $r^*$ with increasing interaction with the target.

Both of the effects (1) and (2) above result in a progressive *increase* in the admittance of the measurement probe with increasing interaction with the target (see Eqns. 2). Thus, whether or not one or both effects are present, interaction between the probe and target produces an unconditional increase in the admittance of the probe. Effects (1) and (2) may be summarized:

$$L' = L - \Delta L(\alpha) \qquad (4a)$$

$$\mathrm{sgn}\{\Delta L(\alpha)\} = \mathrm{sgn}\left\{\frac{d\Delta L(\alpha)}{d\alpha}\right\} = +1 \qquad (4b)$$

$$r^{*\prime} = r^* - \Delta r^*(\alpha) \qquad (5a)$$

$$\mathrm{sgn}\{\Delta r^*(\alpha)\} = \mathrm{sgn}\left\{\frac{d\Delta r^*(\alpha)}{d\alpha}\right\} = +1 \qquad (5b)$$

Above, $\alpha$ is an "interaction parameter" which takes a value between 0 (no interaction between probe and target) and +1 (maximum interaction between probe and target). By inspection of Eqns. 2, we see that Eqns. 5 are equivalent to the union of Eqns. 4, with the conditions

$$r = r + \Delta r(\alpha) \qquad (6a)$$

$$\mathrm{sgn}\{\Delta r(\alpha)\} = \mathrm{sgn}\left\{\frac{d\Delta r(\alpha)}{d\alpha}\right\} = +1 \qquad (6b)$$

**Overview of the operation of the measurement device**

In operation, the measurement probe may be driven by a probe input signal from a frequency source regulated to a fixed or constant frequency. The frequency of the source $\omega_1$ is regulated to below the resonance frequency $\omega_0$ of the measurement probe in the absence of interaction with the target for all operating conditions of the measurement device (Eqn. 3) and at a frequency which is not below the frequency $\omega_L = R^*/L$ where $R^*$ is the sum of the source impedance from which the probe is driven and the resistance of the probe. A signal transmitted through the probe may constitute a probe output signal. In the case that a target is present, the amplitude of the output signal is modulated via the change in the admittance of the probe brought about by the probe-target interaction. The stronger the interaction (and therefore, in general, the closer the target to the measurement probe), the more the admittance of the probe is reduced from its original value (Eqns. 4, 5, 6, and 2) and hence the larger the probe output signal amplitude.

The changes in the admittance of the probe responsible for the signal can be considered to be derived from two interlinked but distinct effects:

*(i)* Modification of the resonance frequency of the measurement probe.
*(ii)* Modification of the quality factor of the measurement probe.

For the case that Eqns. 4 and 5 hold, the admittance of the measurement probe in the presence of interaction with the target is (from Eqns. 2, 4 and 5)

$$Y' = \frac{1}{r^* - \Delta r^*(\alpha)} + \frac{1}{j\omega(L - \Delta L(\alpha))} + j\omega C \qquad (7)$$

**Effect on probe admittance of probe-target interaction mediated changes in the resonance frequency of the measurement probe**

From Eqn. 7, it is evident that interaction with the target brings about a shift in the resonance frequency of the measurement probe from its original value $\omega_0$ (Eqn. 3) to a new value

$$\omega_0' = \frac{1}{\sqrt{(L - \Delta L(\alpha))C}} \qquad (8)$$

In the limit of small $\Delta L/L$, Eqn. 8 may be written

$$\omega_0'(\alpha) = \omega_0 \sqrt{1 + \frac{\Delta L(\alpha)}{L}} \approx \omega_0 \left(1 + \frac{\Delta L(\alpha)}{2L}\right) \qquad (9)$$

We can see from Eqn. 9 that the resonance frequency in the presence of probe-target interaction $\omega_0'$ is always larger than $\omega_0$, the resonance frequency in the absence of probe-target interaction.
As alluded to above, the driving frequency of the measurement probe $\omega_1$ is regulated to below $\omega_0$ in the absence of interaction with the target and may therefore be expressed

$$\omega_1 = \omega_0(1 - \epsilon), \qquad \epsilon > 0 \qquad (10)$$

Where $\varepsilon$ (a positive real number less than unity) is the "initial detuning"

$$\epsilon = \frac{\omega_0 - \omega_1}{\omega_0} \qquad (11)$$

For a given implementation of the measurement device, the initial detuning may be chosen via a process of empirical optimization which involves (other ways of determining this initial detuning may be used):

• Measuring the amplitude of the measurement device output in response to the proximity of a representative conducting target over a range of potential driving frequencies.
• Quantifying the change in the electrical characteristics of the measurement probe over the required range of operating temperatures.

In one preferred implementation of the system, a single operating frequency $\omega_1$ may be chosen so as to optimize the performance and temperature stability of the measurement device, given environmental constraints. In other, more complex implementations of the measurement device, it may be arranged that the frequency at which the measurement probe is driven is varied in response to changes in its temperature (which might for example be determined using a DC conductance measurement). (Note however that in any implementation, the frequency of the frequency source is always regulated to below the resonance frequency of the measurement probe, both in the absence of, and in the presence of, interaction with the target.)

In the presence of probe-target interaction, the detuning may take a modified value

$$\epsilon'(\alpha) = \frac{\omega_0'(\alpha) - \omega_1}{\omega_0(\alpha)'} \qquad (12)$$

which, from Eqns. 9 and 10, may be written

$$\epsilon'(\alpha) = \epsilon + \frac{\Delta L(\alpha)}{2L}(1 - \epsilon) \qquad (13)$$

confirming that detuning from resonance increases as the interaction increases, leading to a corresponding increase in the admittance of the resonant probe at $\omega_1$.

**Effect on probe admittance of probe-target interaction mediated changes in the quality factor of the measurement probe**

The quality factor $Q$ of the measurement probe in the absence of probe-target interaction may be given by:

$$Q = \frac{\omega_0 L}{r} = \frac{1}{r}\sqrt{\frac{L}{C}} \qquad (14)$$

In the presence of interaction, this value may be modified to

$$Q'(\alpha) = \frac{\omega_0'(L - \Delta L(\alpha))}{r + \Delta r(\alpha)} \qquad (15)$$

which using Eqns. 9 and 14, may be written (in the limit of small $\Delta L/L$)

$$Q'(\alpha) = Q\frac{\left(1 - \dfrac{\Delta L(\alpha)}{2L}\right)}{\left(1 + \dfrac{\Delta r(\alpha)}{r}\right)} \qquad (16)$$

Thus, probe-target interactions may reduce the effective quality factor of the probe; an effect which leads to a corresponding increase in the admittance of probe at the driving frequency at $\omega_1$.

**Net effect on probe admittance of probe-target interaction**

Figure 5 summarizes the effect on the probe admittance of the probe-target interaction. Plotted schematically is the admittance $Y$ of the probe as a function of frequency $\omega$ in the region of the resonance at $\omega_0$ for the case that no target is present (solid) and for the case that a target is present (dashed). As indicated by the large grey arrows, the minimum of the admittance moves upward and to the right as a result of interaction with the target. The upward motion is associated with the change in $Q$ of the measurement probe, the rightward motion with the change in its resonance frequency. Both the rightward and upward motion may contribute to a net increase in admittance $\Delta Y_0$.

**Physical origin of the electrical characteristics of the probe assembly**

The physical mechanism responsible for the particular electrical response of the measurement probe outlined above is a "compression" of the flux emanating from the coil inside it as a result of interaction with the target (see WO2007GB00350 and associated applications). In this explanatory section we present a simple model of this effect with reference to Fig. 6.

Were the measurement probe suspended far from any electrically conducting surfaces, the instantaneous magnetic field pattern around it when excited would resemble that of a bar magnet; lines of flux would wrap in closed loops around its ends, extending far out into space.

However, in the context of the measurement device, the measurement probe is not suspended in free space, but may be surrounded by a cylindrical conducting (generally metallic) screen of radius $R_s$ which may be open at one end (Fig. 6(a)). The thickness $t_s$ of the screen may be arranged to be larger than the skin depth $\delta_1$ at the operating frequency $\omega_1$. That is

$$t_s > \delta_1 = \sqrt{\frac{2}{\omega_1 \mu_1 \sigma_1}}$$

$$(17)$$

where $\mu_1$ and $\sigma_1$ are respectively the permeability and conductivity of the screen material. For practical materials at typical operating frequencies, the condition of Eqn. 17 is readily satisfied with screens having thicknesses of order 1 mm or less. (For example, even for very low conductivity stainless steel; $\sigma_1 \sim 10^6$ Sm$^{-1}$, $\mu_1 \sim \mu_0$, at $\omega_1 = 2\pi$ x 30 MHz, $\delta_1 \sim 0.1$ mm) .

The magnetic flux originated by the coil inside the measurement probe may be accordingly confined by the screen in the direction parallel to its axis.

**Analysis of the operation of the measurement probe based on a "flux compression" model of probe-target interactivity**

In the absence of a target, the magnetic flux originated by the coil inside the measurement probe extends a distance from its unscreened end which is comparable with its diameter (Fig. 6a). The volume occupied by this flux thus defines a finite "sensitive volume". When the target enters the sensitive volume, the effect is - by analogy with the description of the screen above - an axial confinement or "compression" of the magnetic flux (Fig. 6b). The effect of this axial compression on the inductance of the coil may be quantified by considering its effect on the magnetic field emanating from the end proximal to the target as the probe-target distance is varied. We elaborate on this description with reference to Figs. 6 and 7.

Figure 6 shows a screened coil in the absence of a target (a) and in the presence of (b) a target. As a first step in our analysis we identify a number of important geometrical parameters with reference to Fig. 7a.

The "coil cross section" $A_1$ is

$$A_1 = \pi R^2 \qquad (18)$$

where $R$ is the radius of the coil. The "annular cross section" $A_2$ is given by

$$A_2 = \pi R_s^2 - A_1 \qquad (19)$$

Both $A_1$ and $A_2$ are independent of probe-target interaction. The relationship between the current $I$ flowing in the coil and the magnetic field must, by Maxwell's relations, satisfy

$$\frac{1}{\mu_0} \oint \boldsymbol{B}\, d\boldsymbol{l} = NI$$

$$(20)$$

where $N$ is the number of turns on the coil and we make the simplifying assumption that the magnetic permeability in the system is everywhere equal to that of free space, $\mu_0$.

We now apply the relation of Eqn. 20 to the measurement probe system assuming that a conducting target is positioned a distance d from the unscreened end of the coil inside it (Figs 7a and 7b) and the other end of the coil is screened at a distance $d^*$ (note that in general, $d^*$ exceeds the maximum value of $d$). We can evaluate the integral around a rectangular contour of dimensions $l_1$ (axial) by $l_2$ (radial) where $l_1$ is the length of the coil and $l_2$ is approximately $2r_w$ where $r_w$ is the radius of the wire from which the coil is wound, to obtain

$$\frac{1}{\mu_0}\{(B_1 + B_2)l_1 + (B_3 + B_4)l_2\} = NI \tag{21}$$

Here, we assume that along the part of the contour through the centre of the coil the field takes a value $B_1$, along the part of the contour through the annular region between the coil and the screen, a value $B_2$ (both $B_1$ and $B_2$ being directed along the coil axis), and along the two short sides of the contour values $B_3$ (target end) and $B_4$ (screened end) (see Fig. 7(b)). $B_3$ and $B_4$ are directed perpendicular to the axis of the coil and are associated with what is commonly referred to as "end effects" (and would be zero for a coil of infinite length).

From the condition $\nabla \cdot \boldsymbol{B} = 0$ we can write

$$B_1 A_1 = B_2 A_2 = 2\pi R d B_3 \tag{22}$$
$$= 2\pi R d^* B_4$$

Combining Eqns. (21) and (22), we obtain an expression for the magnetic field $B_1$ as a function of the probe-target distance d solely in terms of the coil geometry

$$B_1(\alpha) = \frac{\mu_0 NI}{\left(1 + \frac{A_1}{A_2}\right)l_1 + \frac{A_1}{2\pi R}\left(\frac{1}{d} + \frac{1}{d^*}\right)l_2} \tag{23}$$

Finally, from the definition of inductance we have

$$L - \Delta L(\alpha) = \frac{\mu_0 N^2 A_1}{\left(1 + \frac{A_1}{A_2}\right)l_1 + \frac{A_1}{2\pi R}\left(\frac{1}{d} + \frac{1}{d^*}\right)l_2} \tag{24}$$

Note that the form of the expression on the right hand side of Eqn. 24 directly implies the minus sign applied to the $\Delta L(\alpha)$ term on the left i.e. the reduction in inductance with decreasing probe-target distance d alluded to in previous sections.

The change in loss-equivalent resistance $\Delta r(\alpha)$ of the probe associated with probe-target interaction results from the current density $\Delta J_t(\alpha)$ produced in the target by the coil's alternating magnetic field:

$$I_c^2 \Delta r(\alpha) \propto \Delta J_t(\alpha)^2 \delta_t \tag{25}$$

where $\delta_t = \sqrt{\dfrac{2}{\omega_1 \mu_t \sigma_t}}$ is the skin depth in the target (permeability $\mu_t$, conductivity $\sigma_t$). The stronger the interaction, the higher the current density (or in other words, $\Delta J_t(\alpha)$ increases in magnitude as $\alpha$ increases) leading directly to the result summarized by Eqns. 6.

Furthermore, the target may be any of: a rotor blade, surface (including those that have low conductivities), conductive surface, pipe, gas pipe, oil pipe, water pipe, tubing or well casing. For example, the target sensor may be used as a tool for downhole pipe inspection, corrosion or erosion detection, casing or tubing condition evaluation, casing collar location, crack detection and well integrity evaluation especially in the oil and gas industry. In these applications the tool may monitor the surface condition and changes associated with wear, corrosion and eventual failure. Such a tool may work on the inside or outside surfaces of pipes or tubes, for example. This tool works especially well on metallic surfaces and other conductors.

As will be appreciated by the skilled person, details of the above embodiment may be varied without departing from the scope of the present invention, as defined by the appended claims.

Many combinations, modifications, or alterations to the features of the above embodiments will be readily apparent to the skilled person and are intended to form part of the invention. Any of the features described specifically relating to one embodiment or example may be used in any other embodiment by making the appropriate changes.

**Claims**

1. A target measurement device comprising:

   a measurement probe containing a coil and having some inductance and some capacitance and an admittance and a resonance frequency that change as the separation of the measurement probe and a target changes;
   a frequency source arranged to apply at an amplitude, an input alternating signal to the measurement probe;
   a frequency regulator arranged to regulate the input alternating signal at a frequency below the resonance frequency of the measurement probe; and
   a detector arranged to detect an output signal from the measurement probe at the frequency of the frequency source that varies in amplitude with the admittance and resonance frequency of the measurement probe indicating an interaction of the measurement probe with the target,

   **characterised in that**:

   the target measurement device further comprises a circuit arranged to scale the amplitude of the output signal detected by the detector according to the amplitude of the input signal provided by the frequency source; and
   the frequency regulator is arranged such that the frequency source is regulated to a frequency which is, both in the presence and absence of interaction between the measurement probe and a target, simultaneously: (a) not less than $\omega_0/Q$ below the resonance frequency $\omega_0$ of the measurement probe, $Q$ being the quality factor of the measurement probe, and (b) not below the frequency $\omega_L = R^*/L$ where $R^*$ is the sum of a source impedance from which the measurement probe is driven and its resistance, and $L$ is its inductance.

2. The target measurement device of claim 1 further comprising a demodulator arranged to demodulate the output signal from the measurement probe.

3. The target measurement device of claim 1 or claim 2 further comprising a circuit arranged to determine the resonance frequency of the measurement probe.

4. The target measurement device according to any previous claim, wherein the frequency source operates at constant frequency.

5. The target measurement device according to any previous claim further comprising a validation circuit to enable real-time monitoring of the integrity of the measurement device, the validation circuit arranged to pass a current through the measurement probe by connecting the probe between two non-equal voltages $V_A$ and $V_B$ via two resistors: one from $V_A$ to one end of the probe, the other from $V_B$ to the other end of the probe and to measure the resulting voltage difference across the probe.

6. The target measurement device of any previous claim further comprising a second measurement probe mounted axially offset to the first measurement probe and connected to the frequency source; and
   a second detector arranged to separately detect and process the output signal from the second measurement probe.

7. The target measurement device of any of previous claim, wherein the target is selected from the group comprising: a rotor, a rotor blade, a rotor blade tip, a surface, a conductive surface, a pipe, a tube, or a well-casing.

8. A system comprising:

   a plurality of the target measurement device according to any previous claim;
   a transmission line configured to provide an electrical connection between each measurement probe and its corresponding frequency source and detector, wherein each frequency source is configured to supply its corresponding measurement probe with an input alternating signal at a different frequency.

9. A method of measuring target clearance comprising the steps of:

providing a measurement probe containing a coil and having some inductance and capacitance and an admittance and a resonance frequency that change as the separation of the measurement probe and a target changes;

driving the measurement probe with an input alternating signal from a frequency source at an amplitude regulated to a frequency below the resonance frequency of the measurement probe; and

detecting an output signal from the measurement probe at the frequency of the input alternating signal that varies in amplitude with the admittance and resonance frequency of the measurement probe indicating an interaction of the measurement probe with the target, and

**characterised in that**:

the method further comprises scaling the amplitude of the output signal detected according to the amplitude of the input signal provided by the frequency source, and

the frequency source is regulated, both in the presence and absence of interaction between the measurement probe and the target, to a frequency which is, simultaneously: (a) not less than $\omega_0/Q$ below the resonance frequency $\omega_0$ of the measurement probe ($Q$ being the quality factor of the measurement probe), and (b) not below the frequency $\omega_L = R^*/L$ where $R^*$ is the sum of a source impedance from which the measurement probe is driven and its resistance, and $L$ is its inductance.

10. The method according to claim 9 further comprising the step of determining the resonance frequency of the measurement probe in the absence of interaction between the measurement probe and a target and regulating the frequency source to operate below this determined resonance frequency.

11. The method according to claims 9 or 10 further comprising the step of monitoring the integrity of the measurement probe by passing a DC current through the measurement probe which is arranged to flow by connecting the probe between two non-equal voltages $V_A$ and $V_B$ via two resistors: one from $V_A$ to one end of the probe, the other from $V_B$ to the other end of the probe, measuring the voltage difference across the probe and preventing the current path through the probe and the two resistors from loading the frequency source and detector through the use of a filter.

12. The method according to any of claims 9 to 11 further comprising the step of using a fast analogue to digital converter gate array based signal processing circuit to recover information about the profiles of the targets from the probe output signal.

13. The method of any of claims 9 to 12, wherein Q is between 2 and 20.

**Patentansprüche**

1. Zielmessvorrichtung, die Folgendes umfasst:

eine Messsonde, die eine Spule enthält und etwas Induktivität und etwas Kapazität und eine Admittanz und eine Resonanzfrequenz aufweist, die sich ändern, wenn sich die Trennung der Messsonde und eines Ziels ändert;

eine Frequenzquelle, die angeordnet ist, ein alternierendes Eingangssignal mit einer Amplitude auf die Messsonde anzuwenden.

einen Frequenzregler, der angeordnet ist, das alternierende Eingangssignal auf eine Frequenz unter der Resonanzfrequenz der Messsonde zu regeln, und

einen Detektor, der angeordnet ist, ein Ausgangssignal von der Messsonde mit der Frequenz der Frequenzquelle zu detektieren, das in der Amplitude mit der Admittanz und der Resonanzfrequenz der Messsonde variiert, wodurch eine Interaktion der Messsonde mit dem Ziel angezeigt wird,

**dadurch gekennzeichnet, dass**:

die Zielmessvorrichtung ferner eine Schaltung umfasst, die angeordnet ist, die Amplitude des Ausgangssignals, das vom Detektor detektiert wird, gemäß der Amplitude des Eingangssignals, das von der Frequenzquelle bereitgestellt wird, zu skalieren; und

der Frequenzregler derart angeordnet ist, dass die Frequenzquelle auf eine Frequenz geregelt wird, die sowohl bei Vorhandensein als auch bei Fehlen einer Interaktion zwischen der Messsonde und einem Ziel gleichzeitig Folgendes ist: (a) nicht weniger als $\omega_0/Q$ unter der Resonanzfrequenz $\omega_0$ der Messsonde, wo $Q$ der Qualitätsfaktor der Messsonde ist, und (b) nicht unter der Frequenz $\omega_L = R^*/L$, wo $R^*$ die Summe einer Quellimpedanz, von der die Messsonde angesteuert wird, und ihres Widerstands und L ihre Induktivität ist.

2. Zielmessvorrichtung nach Anspruch 1, die ferner einen Demodulator umfasst, der angeordnet ist, das Ausgangssignal von der Messsonde zu demodulieren.

3. Zielmessvorrichtung nach Anspruch 1 oder 2, die ferner eine Schaltung umfasst, die angeordnet ist, die Resonanzfrequenz der Messsonde zu bestimmen.

4. Zielmessvorrichtung nach einem der vorhergehenden Ansprüche, wobei die Frequenzquelle mit konstanter Frequenz betrieben wird.

5. Zielmessvorrichtung nach einem der vorhergehenden Ansprüche, die ferner eine Validierungsschaltung umfasst, um eine Echtzeitüberwachung der Integrität der Messvorrichtung zu ermöglichen, wobei die Validierungsschaltung angeordnet ist, einen Strom durch die Messsonde zu leiten, indem die Sonde via zwei Widerstände: einer von $V_A$ zu einem Ende der Sonde, der andere von $V_B$ zum anderen Ende der Sonde zwischen zwei nicht gleichen Spannungen $V_A$ und $V_B$ angeschlossen wird, und die resultierende Spannungsdifferenz über die Sonde zu messen.

6. Zielmessvorrichtung nach einem der vorhergehenden Ansprüche, die eine zweite Messsonde umfasst, die axial zur ersten Messsonde versetzt montiert und an der Frequenzquelle angeschlossen ist; und
einen zweiten Detektor, der angeordnet ist, das Ausgangssignal von der zweiten Messsonde separat zu detektieren und zu verarbeiten.

7. Zielmessvorrichtung nach einem der vorhergehenden Ansprüche, wobei das Ziel ausgewählt wird aus der Gruppe, die Folgendes umfasst: einen Rotor, ein Rotorblatt, eine Rotorblattspitze, eine Oberfläche, eine leitfähige Oberfläche, eine Leitung, ein Rohr oder eine Bohrlochverrohrung.

8. System, das Folgendes umfasst:

eine Vielzahl der Zielmessvorrichtung nach einem der vorherigen Ansprüche;
eine Übertragungsleitung, die dazu ausgelegt ist, zwischen jeder Messsonde und deren entsprechender Frequenzquelle und entsprechendem Detektor eine elektrische Verbindung bereitzustellen, wobei jede Frequenzquelle dazu ausgelegt ist, ihre entsprechende Messsonde mit einem alternierenden Eingangssignal mit einer anderen Frequenz zu versorgen.

9. Verfahren zum Messen eines Zielspiels, das folgende Schritte umfasst:

Bereitstellen einer Messsonde, die eine Spule enthält und etwas Induktivität und Kapazität und eine Admittanz und eine Resonanzfrequenz aufweist, die sich ändern, wenn sich die Trennung der Messsonde und eines Ziels ändert;
Ansteuern der Messsonde mit einem alternierenden Eingangssignal von einer Frequenzquelle mit einer Amplitude, die auf eine Frequenz unter der Resonanzfrequenz der Messsonde geregelt ist; und
Detektieren eines Ausgangssignals von der Messsonde mit der Frequenz des alternierenden Eingangssignals, das in der Amplitude mit der Admittanz und der Resonanzfrequenz der Messsonde variiert, wodurch eine Interaktion der Messsonde mit dem Ziel angezeigt wird, und

**dadurch gekennzeichnet, dass**:

das Verfahren ferner das Skalieren der Amplitude des detektierten Ausgangssignals gemäß der Amplitude des Eingangssignals, das von der Frequenzquelle bereitgestellt wird, umfasst und die Frequenzquelle auf eine Frequenz geregelt wird, die sowohl bei Vorhandensein als auch bei Fehlen einer Interaktion zwischen der Messsonde und dem Ziel gleichzeitig Folgendes ist: (a) nicht weniger als $\omega_0/Q$ unter der Resonanzfrequenz $\omega_0$ der Messsonde (wo $Q$ der Qualitätsfaktor der Messsonde ist), und (b) nicht unter der Frequenz $\omega_L = R^*/L$, wo $R^*$ die Summe einer Quellimpedanz, von der die Messsonde angesteuert wird, und ihres Widerstands und $L$ ihre Induktivität ist.

**10.** Verfahren nach Anspruch 9, das ferner den Schritt des Bestimmens der Resonanzfrequenz der Messsonde bei Fehlen der Interaktion zwischen der Messsonde und einem Ziel umfasst und des Regelns der Frequenzquelle, um unter der bestimmten Resonanzfrequenz betrieben zu werden.

**11.** Verfahren nach Anspruch 9 oder 10, das ferner den Schritt des Überwachens der Integrität der Messsonde durch Leiten eines DC-Stroms durch die Messsonde umfasst, der angeordnet ist, durch Anschließen der Messsonde via zwei Widerstände: einen von $V_A$ zu einem Ende der Messsonde und einen von $V_B$ zum anderen Ende der Messsonde zwischen zwei nicht gleichen Spannungen $V_A$ und $V_B$ zu fließen, des Messens der Spannungsdifferenz über die Sonde und des Verhinderns, dass der Strompfad durch die Sonde und die zwei Widerstände durch die Verwendung eines Filters die Frequenzquelle und den Detektor belastet.

**12.** Verfahren nach einem der Ansprüche 9 bis 11, das ferner den Schritt des Verwendens einer Signalverarbeitungsschaltung auf Basis eines schnellen Analog-Digital-Wandler-Gate-Arrays umfasst, um Informationen über die Profile des Ziels aus dem Sondenausgangssignal zurückzugewinnen.

**13.** Verfahren nach einem der Ansprüche 9 bis 12, wobei Q zwischen 2 und 20 beträgt.

**Revendications**

**1.** Dispositif de mesure de cible comprenant :

une sonde de mesure contenant une bobine et présentant une certaine inductance et une certaine capacitance et une admittance et une fréquence de résonance qui changent tandis que la séparation de la sonde de mesure et d'une cible change ;
une source de fréquence conçue pour appliquer à une amplitude, un signal alternatif d'entrée à la sonde de mesure ;
un régulateur de fréquence conçu pour réguler le signal alternatif d'entrée à une fréquence inférieure à la fréquence de résonance de la sonde de mesure ; et
un détecteur conçu pour détecter un signal de sortie provenant de la sonde de mesure à la fréquence de la source de fréquence qui varie en amplitude avec l'admittance et la fréquence de résonance de la sonde de mesure indiquant une interaction de la sonde de mesure avec la cible,

**caractérisé en ce que** :

le dispositif de mesure de cible comprend en outre un circuit conçu pour réduire l'amplitude du signal de sortie détecté par le détecteur en fonction de l'amplitude du signal d'entrée fourni par la source de fréquence ; et
le régulateur de fréquence est conçu de manière que la source de fréquence est régulée jusqu'à une fréquence qui est, à la fois en présence et en l'absence d'interaction entre la sonde de mesure et une cible, simultanément :
(a) non inférieure à $\omega_0/Q$ au-dessous de la fréquence de résonance $\omega_0$ de la sonde de mesure, Q représentant le facteur de qualité de la sonde de mesure, et (b) non inférieure à la fréquence $\omega_L = R^*/L$, où $R^*$ représente la somme d'une impédance de source à partir de laquelle la sonde de mesure est entraînée et de sa résistance, et L représente son inductance.

**2.** Dispositif de mesure de cible selon la revendication 1, comprenant en outre un démodulateur conçu pour démoduler le signal de sortie provenant de la sonde de mesure.

**3.** Dispositif de mesure de cible selon la revendication 1 ou la revendication 2, comprenant en outre un circuit conçu pour déterminer la fréquence de résonance de la sonde de mesure.

**4.** Dispositif de mesure de cible selon l'une quelconque des revendications précédentes, dans lequel la source de fréquence fonctionne à une fréquence constante.

**5.** Dispositif de mesure de cible selon l'une quelconque des revendications précédentes, comprenant en outre un circuit de validation pour permettre la surveillance en temps réel de l'intégrité du dispositif de mesure, le circuit de validation étant conçu pour faire passer un courant par la sonde de mesure en connectant la sonde entre les tensions non égales $V_A$ et $V_B$ par le biais de deux résistances : une de $V_A$ à une extrémité de la sonde, l'autre de $V_B$ à l'autre extrémité de la sonde et pour mesurer la différence de tension obtenue à travers la sonde.

**6.** Dispositif de mesure de cible selon l'une quelconque des revendications précédentes, comprenant en outre une deuxième sonde de mesure décalée de manière axiale par rapport à la première sonde de mesure et connectée à la source de fréquence ; et
un deuxième détecteur conçu pour détecter et traiter séparément le signal de sortie provenant de la deuxième sonde de mesure.

**7.** Dispositif de mesure de cible selon l'une quelconque des revendications précédentes, dans lequel la cible est choisie dans le groupe comprenant : un rotor, une pale de rotor, une extrémité de pale de rotor, une surface, une surface conductrice, un tuyau, un tube ou un tubage de puits.

**8.** Système comprenant :

une pluralité de dispositifs de mesure de cible selon l'une quelconque des revendications précédentes;
une ligne de transmission conçue pour permettre une connexion électrique entre chaque sonde de mesure et sa source et son détecteur de fréquence correspondants, chaque source de fréquence étant conçue pour fournir à sa sonde de mesure correspondante un signal alternatif d'entrée à une fréquence différente.

**9.** Procédé de mesure d'un dégagement de cible comprenant les étapes consistant à :

fournir une sonde de mesure contenant une bobine et ayant une certaine inductance et capacitance et une admittance et une fréquence de résonance qui changent tandis que la séparation de la sonde de mesure et d'une cible change ;
entraîner la sonde de mesure avec un signal alternatif d'entrée provenant d'une source de fréquence à une amplitude régulée jusqu'à une fréquence inférieure à la fréquence de résonance de la sonde de mesure ; et
détecter un signal de sortie provenant de la sonde de mesure à la fréquence du signal alternatif d'entrée qui varie en amplitude avec l'admittance et la fréquence de résonance de la sonde de mesure indiquant une interaction de la sonde de mesure avec la cible, et

**caractérisé en ce que** :

le procédé comprend en outre la réduction de l'amplitude du signal de sortie détecté en fonction de l'amplitude du signal d'entrée fourni par la source de fréquence, et
la source de fréquence est régulée, à la fois en présence et en l'absence d'interaction entre la sonde de mesure et la cible, jusqu'à une fréquence qui est, simultanément : (a) non moins de $\omega_0 / Q$ au-dessous de la fréquence de résonance $\omega_0$ de la sonde de mesure ($Q$ représentant le facteur de qualité de la sonde de mesure) et (b) pas au-dessous de la fréquence $\omega_L = R^*/L$, où $R^*$ représente la somme d'une impédance de source à partir de laquelle la sonde de mesure est entraînée et de sa résistance, et $L$ représente son inductance.

**10.** Procédé selon la revendication 9, comprenant en outre l'étape consistant à déterminer la fréquence de résonance de la sonde de mesure en l'absence d'interaction entre la sonde de mesure et une cible et à réguler la source de fréquence pour fonctionner au-dessous de cette fréquence de résonance déterminée.

**11.** Procédé selon les revendications 9 ou 10, comprenant en outre l'étape consistant à surveiller l'intégrité de la sonde de mesure en faisant passer un courant CC par la sonde de mesure qui est conçu pour s'écouler en connectant la sonde entre deux tensions non égales $V_A$ et $V_B$ par le biais de deux résistances : une de $V_A$ à une extrémité de la sonde, l'autre de $V_B$ à l'autre extrémité de la sonde, à mesurer la différence de tension à travers la sonde et à empêcher le trajet de courant traversant la sonde et les deux résistances de charger la source de fréquence et le détecteur par l'utilisation d'un filtre.

**12.** Procédé selon l'une quelconque des revendications 9 à 11, comprenant en outre l'étape consistant à utiliser un réseau prédiffusé de convertisseur analogique-numérique en fonction d'un circuit de traitement de signal pour récupérer des informations sur les profils des cibles provenant du signal de sortie de la sonde.

**13.** Procédé selon l'une quelconque des revendications 9 à 12, dans lequel $Q$ se situe entre 2 et 20.

# Figure 1a

Rear of engine ◄──────  ──────► Front of engine

Casing

$d_r$

Turbine blade tip

Turbine blade

$\omega_t$

Turbine shaft

Axis of turbine blades
when engine cold and unloaded ($d_a = 0$)

# Figure 1b

Rear of engine ◄──────  ──────► Front of engine

$d_a = d_a - \Delta d_a$    $d_a = 0$    $d_a = d_a + \Delta d_a$

"Negative" axial shift
of turbine blades

"Positive" axial shift
of turbine blades

Rear of engine — Resonant probe 2 — Resonant probe 1 — Front of engine

Casing

$d_r$

Turbine blade — Turbine blade tip

$\omega_t$

Turbine shaft

$d_a = d_a - \Delta d_a$
"Negative" axial shift of turbine blades

$d_a = d_a + \Delta d_a$
"Positive" axial shift of turbine blades

$d_a = 0$
Axis of turbine blades when engine cold and unloaded

**Figure 1c**

## Figure 2a

Input

Resonant probe

Measurement circuitry

Output

RF magnetic field

## Figure 2b

Resonant measurement probe

Blade tip    RF magnetic field in this region

coil

Tip speed $v_t$

to measurement circuitry

Temperature resistant package

Figure 3

Figure 4a

Figure 4b

Figure 5

EP 2 713 137 B1

Sensitive volume

Blade tip

$R_s$

$R$

$t_s$

Figure 6a

Figure 6b

23

Figure 7a

Figure 7b

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 2010213929 A
- WO 2010082035 A
- DE 3305546 A
- WO 2007GB00350 A